Europäisches Patentamt

(19) European Patent Office

Office européen des brevets

(11) Publication number : **0 500 233 A2**

(12) **EUROPEAN PATENT APPLICATION**

(21) Application number : 92300994.8

(22) Date of filing : 06.02.92

(51) Int. Cl.$^5$ : **H01L 29/08**, H01L 27/06, H01L 21/82

(30) Priority : **14.02.91 US 655676**

(43) Date of publication of application :
**26.08.92 Bulletin 92/35**

(84) Designated Contracting States :
**DE FR GB IT**

(71) Applicant : **NATIONAL SEMICONDUCTOR CORPORATION**
**2900 Semiconductor Drive P.O. Box 58090**
**Santa Clara California 95051-8090 (US)**

(72) Inventor : **Robinson, Murray J.**
**2 Lakeside Drive**
**Falmouth, Maine 04105 (US)**
Inventor : **Joyce, Christopher C.**
**23 Church Street**
**Gorham, Maine 04038 (US)**
Inventor : **Luk, Tim Wah**
**8 Bayberry Lane**
**Scarborough, Maine 04074 (US)**

(74) Representative : **Bowles, Sharon Margaret et al**
**BOWLES HORTON Felden House Dower Mews High Street**
**Berkhamsted Hertfordshire HP4 2BL (GB)**

(54) **Bipolar transistor structure & BICMOS IC fabrication process.**

(57) A localized subemitter collector region (SEC) is formed in the buried collector layer (BCL) underlying the emitter region (E) and active base region layer (ABL) of a bipolar transistor structure (12). The subemitter collector region (SEC) is implanted with relatively fast diffusing N type atoms distributed in a retrograde concentration upward from the buried collector layer (BCL) into the epitaxial layer (EPI) and preferably up to the active base region layer (ABL) below the emitter region (E). Preferably, phosphorous atoms are implanted in the subemitter collector region to a relatively high N+ concentration. The subemitter collector region (SEC) occupies a horizontal cross section area approximately 10% to 20% of the horizontal cross section area of the buried collector layer. The bipolar NPN transistor structure (12) is incorporated in a BICMOS integrated circuit. In the BICMOS IC fabrication process the NWELL definition and implant mask for the CMOS transistor structure is also a subemitter collector definition and implant mask providing an SEC definition opening for the bipolar transistor structure. The field oxide definition mask with framing field oxide openings (20) for the CMOS transistor structure is also a collector base surface spacer region definition mask with a CBSS defining opening (22) over the bipolar transistor structure.

EP 0 500 233 A2

FIG 2

Technical wield

This invention relates to a new integrated circuit bipolar transistor structure incorporating a retrograde "N well" subemitter collector. The invention is particularly applicable for BICMOS integrated circuits and provides a new BICMOS process for fabrication of the new bipolar transistor structure. The invention uses selected mask sequences from the CMOS transistor structure fabrication steps with modification of the masks according to the invention to form the new bipolar transistor structure.

Background Art

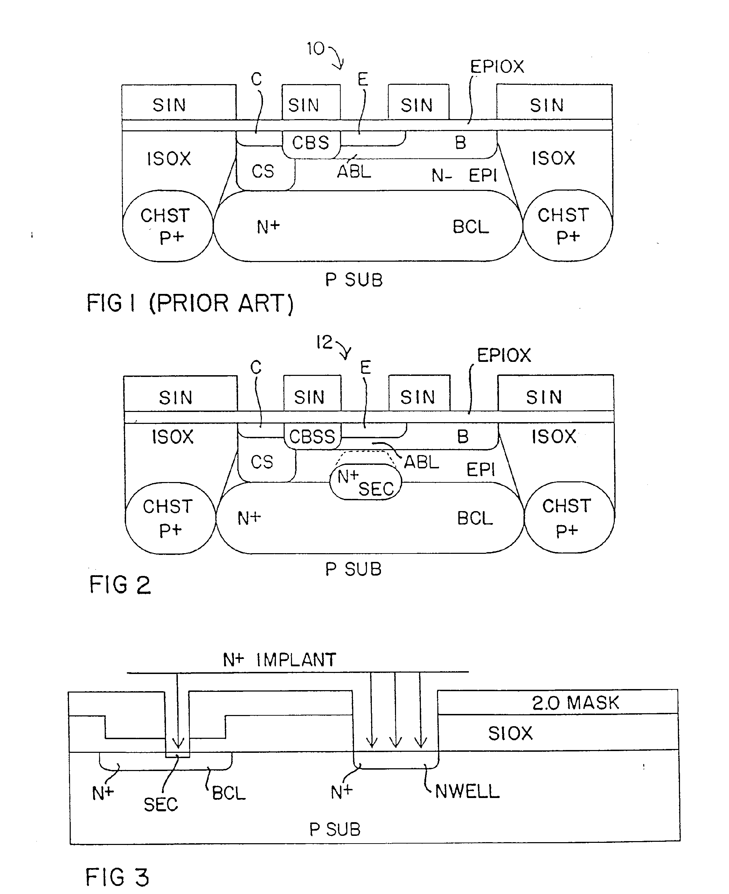

A generalized prior art integrated circuit bipolar NPN transistor structure 10 is illustrated in FIG. 1. The bipolar transistor structure 10 is used in both bipolar and BICMOS integrated circuits and in the example of FIG. 1 is fabricated on a substrate SUB of P type semiconductor material. A buried collector layer BCL is formed in the azsubstrate using a conventional mask, etch and implant sequence. An N+ concentration of relatively slow diffusing N type antimony atoms is implanted through the BCL mask to form the buried collector layer. Channel stop regions CHST are formed on either side of the BCL using a mask, etch and implant sequence for implanting a P+ concentration of P type boron atoms. The channel stop regions CHST prevent parasitic MOS transistor effects between the BCL and adjacent integrated circuit regions.

An epitaxial layer EPI forming a single crystal of N type semiconductor material is deposited over the substrate. A thin protective layer EPIOX of epitaxial oxide ($SiO_2$) is grown over the EPI layer and a passivating layer SIN of silicon nitride ($Si_3N_4$) is deposited over the EPIOX. The isolation oxide regions ISOX are then formed by a conventional isolation oxide mask, etch and oxidation sequence. The isolation oxide regions ISOX isolate the active area of the bipolar transistor element 10 in the form of an epitaxial island from adjacent components.

Using respective mask, etch and implant sequences, the collector sink CS, collector C, base B, and emitter E regions are implanted in the epitaxial layer EPI over the buried collector layer BCL. The collector sink region CS is typically implanted with an N+ concentration of N type phosphorous through the sink mask. The isolation oxide regions may be implanted at the same time with N type atoms for gettering contaminants. The base region B is typically implanted with P type boron atoms. The collector C and emitter E regions are implanted with an N+ concentration of, for example, N type arsenic atoms.

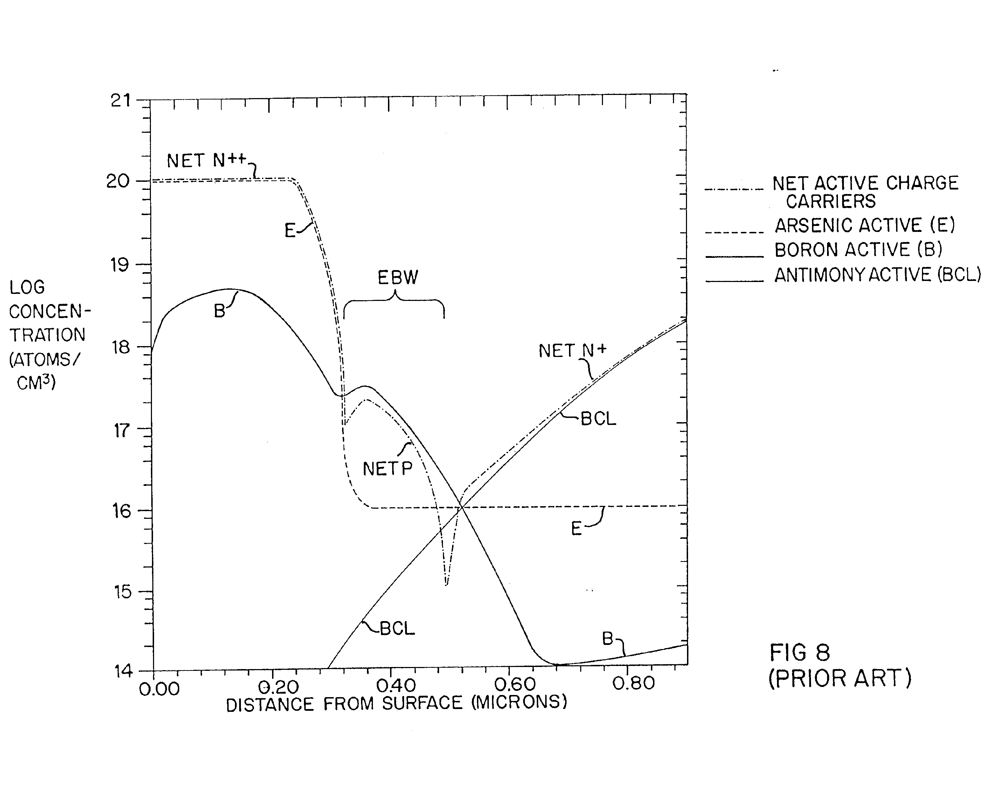

The emitter region E is formed in the base region B with an active base region layer ABL below the emitter region. The buried collector layer BCL is separated from the active base layer ABL and emitter region E by semiconductor material of the EPI layer. The collector sink region CS electrically couples the collector region C with the buried collector layer BCL joining the N+ doped regions. The transistor action electron current is in the vertical direction from the emitter region E through the active base layer ABL to the buried collector layer BCL. The electron current is modulated by the active base layer ABL and must pass through the lower concentration of N type atoms in the EPI layer which increases the effective base width EBW of the active base layer as shown in the graph of FIG. 8.

FIG. 8 shows a graph on a logarithmic scale of concentrations of respective P and N type dopant atoms along a vertical profile from the surface at the emitter region E down to the buried collector layer BCL. Starting at the surface, in the emitter region E the net concentration is a very high concentration of N type carriers indicated by the two plus signs N++. The net concentration of carriers in the active base layer ABL is an intermediate concentration of P type carriers extending into the EPI layer because of the relatively low concentration of N type carriers in the EPI layer. The effective base width EBW therefore extends through the active base layer ABL into the EPI layer. A typical concentration of N type atoms in the middle of the EPI layer in the prior art bipolar transistor structure of FIG. 10 is for example $2 \times 10^{16}$ antimony atoms/cm$^3$. The net concentration of carriers approaching the varied collector layer BCL shifts to N type carriers and increases to a relatively high N+ concentration of N type atoms in the buried collector layer BCL.

Spacing between the collector C and base B is indicated in FIG. 1 by a general designation CBS for a collector base spacer region. According to prior art practice, this collector base spacer region may simply be an extension of the epitaxial layer EPI for example in described in the Howell et al. U.S. Patent No. 4,498,227. Alternatively, a collector base spacer region may be provided by a region of isolation oxide ISOX ($SiO_2$) as described for example in the Desbiens et al. U.S. Patent No. 4,849,344.

In the final stages of wafer fabrication of the bipolar transistor structure 10 of FIG. 1 a contact definition mask is formed using the silicon nitride layer SIN as shown in FIG. 1 for etching the EPIOX layer and depositing a metal contact layer. First and second metal layers may be deposited separated by an interlayer dielectric, and with a final passivation layer.

A disadvantage of the prior art bipolar transistor structure 10 of FIG. 1 is that the relatively great effective base width EBW caused by the relatively low N concentration of the EPI layer slows down the operating speed and increases the capacitance of the NPN transistor. A further problem occurs because of the early onset of the so called kirk effect at a relatively low current density. According to the Kirk effect, at a critical current density, further increase in current increases the effective base width EBW slowing down the transistor operating speed. This undesirable onset of the kirk effect is related to the relatively low conductivity or low concentration of carriers presented by the EPI layer in the active electron current path of the transistor. The relatively great effective base width EBW of the prior art bipolar transistor structure also limits the maximum frequency Ft of the transistor at which the amplification factor $\beta > 1$, i.e. the maximum frequency of operation at unity gain or greater.

### Objects of the Invention

It is therefore an object of the present invention to provide a new bipolar transistor structure with narrower effective base width EBW for increased operating speed and reduced capacitance.

Another object of the invention is to increase the concentration of N type charge carriers locally in the epitaxial layer EPI below the active base layer ABL in order to reduce adverse Kirk effects. The invention increases the critical current density level of onset of the kirk effect. By decreasing effective base width EBW and deferring onset of the kirk effect, the invention also increases the maximum frequency Ft at which the amplification factor $\beta$ of the NPN bipolar transistor structure provides unity or greater gain.

A further object of the invention is to provide a new bipolar transistor structure applicable for both bipolar integrated circuits and BICMOS integrated circuits. The invention therefore also includes a new BICMOS IC structure. To this end the invention provides a fabrication process using BICMOS mask sequences modified for forming the novel elements of the bipolar transistor structure at the same time as forming elements of the CMOS transistor structures. An object of the invention is therefore to provide new mask structures and new mask, etch, implant and oxidation process sequences for fabricating the improved bipolar transistor structure in BICMOS integrated circuits without increasing the process steps.

### Disclosure of the Invention

In order to accomplish these results the invention provides a localized subemitter collector (SEC) region formed in the buried collector layer underlying the emitter region and active base region layer. The subemitter collector region comprises relatively fast diffusing N type atoms distributed in a retrograde concentration upward from the buried collector layer into the epitaxial layer. In the preferred example, the relatively fast diffusing N type atoms are distributed in a retrograde concentration upward from the buried collector layer to the active base region layer below the emitter region. In the preferred example the relatively fast diffusing N type atoms are phosphorous atoms selectively implanted to a relatively high N+ concentration in the buried collector layer. The subemitter collector region occupies a horizonal cross section area preferably approximately 10% to 20% of the horizontal cross section area of the buried collector layer.

The invention also provides a BICMOS integrated circuit structure incorporating the new bipolar NPN transistor structure along with a CMOS transistor structure including complementary NMOS and PMOS transistor structures. The CMOS transistor structure includes source and drain regions formed in the epitaxial layer separated by a channel region. A gate is formed over the channel region separated by a gate oxide layer. An N well is initially formed in the substrate to underlay the source, drain and channel regions. The CMOS transistor structure is framed by field oxide regions.

According to the invention the N well (NWELL) of the CMOS transistor structure is a retro N well also comprising the relatively fast diffusing N type atoms distributed in a retrograde concentration upward from the substrate into the epitaxial layer to the source, drain, and channel regions. Similarly the subemitter collector region of the bipolar transistor structure is a retro subemitter collector region comprising the relatively fast diffusing N type atoms distributed in a localized retrograde concentration upward from the buried collector layer into the epitaxial layer. Another interrelated feature is that the invention provides in the bipolar transistor structure a surface spacer region between the collector and base regions comprised of the field oxide.

An advantage of the new subemitter collector region with a retrograde concentration of N type atoms extending to the active base layer similar in structure to the CMOS retrograde concentration N well is that it substantially reduces the effective base width thereby increasing the operating speed and reducing capacitance of the bipolar transistor structure. Furthermore the substantial increase in concentration of N type carriers on the collector side of the active base layer substantially reduces onset of the Kirk effect and increases the maximum frequency of operation Ft at unity or greater gain.

The invention also provides an improved BICMOS fabrication process for forming the bipolar and CMOS transistor structures. The invention provides the step of forming the N well of the CMOS transistor structure in the substrate using an N well definition mask, etch and implant sequence before deposition of the epitaxial layer and after forming the buried collector layer of the bipolar transistor structure in the substrate. According to the invention the process continues by constructing the N well definition mask also as a subemitter collector definition mask with a submitter collector defining opening over the buried collector layer of the bipolar transistor structure. The process proceeds further by implanting the relatively fast diffusing N type atoms through a CMOS N well defining opening in the N well definition mask. At the same time the relatively fast diffusing N type atoms are implanted through the subemitter collector defining opening to form the subemitter collector region in the buried collector layer of the bipolar transistor structure.

The BICMOS process involves at least one annealing step after deposition of the epitaxial layer, formation of the source, drain and channel regions of the CMOS transistor structure in the epitaxial layer, and formation of the collector, base and emitter regions of the bipolar transistor structure in the epitaxial layer. The annealing step produces up diffusion of the relatively fast diffusing N type atoms implanted in the buried collector layer forming a subemitter collector region having a retrograde concentration of the N type atoms distributed from the buried collector layer through the epitaxial layer to the active base region layer. At the same time up diffusion from the N well in the CMOS transistor element provides the retro N well.

An advantage of the retrograde concentration subemitter collector region is that it improves and increases the concentration of N type carriers in the epitaxial layer adjacent to the active base layer by a factor of at least 3 to 4 times for example from $2x10^{16}$ to $6x10^{16}$. The effect of the increased N type charge carriers in the epitaxial layer is to move the collector closer to the active base layer and reduce the effective base width. According to the invention the increased concentration of N type carriers provided by the subemitter collector region and accompanying retrograde concentration is localized to the active electron current path from the emitter through the active base layer to the buried collector region. This is accomplished by limiting the horizontal cross section area of the subemitter collector region to approximately 10% to 20% of the horizontal cross section area of the buried collector layer and locating it under the active base layer.

The BICMOS process also provides the step of constructing the field oxide definition mask also as a collector base surface spacer region definition mask with a CBSS defining opening over the bipolar transistor structure. A field oxide surface spacer region separating the collector region from the base region is therefore grown at the same time as the framing field oxide for the CMOS transistor element. A feature of the new field oxide surface spacer region is that it is incorporated as part of a self aligned transistor mask providing the collector, emitter and base contact definition mask.

In addition to the new bipolar transistor structure, BICMOS integrated circuit structure, and BICMOS process, the invention also provides new BICMOS integrated circuit photodefinition mask structures including the new retro N well photodefinition mask also forming the subemitter collector definition mask, a new field oxide definition mask also forming the surface spacer region definition mask, and the self aligned transistor mask for the collector, emitter and base contact definition mask.

Brief Description of the Drawings

Figure 1 is a simplified two dimensional diagrammatic view of a prior art bipolar transistor structure.

FIG. 2 is a simplified two dimensional diagrammatic view of a bipolar transistor structure according to the invention.

FIG. 3 is a simplified two dimensional diagrammatic view of the 2.0 mask, etch and implant sequence of the BICMOS fabrication process showing the new 2.0 retro NWELL definition mask with NWELL definition opening for the CMOS transistor structure and also functioning as a subemitter collector definition mask with an SEC definition opening for the bipolar transistor structure.

FIG. 4 is a simplified two dimensional diagrammatic view of the 6.0 mask and etch sequence of the new BICMOS fabrication process showing the 6.0 CMOS active area definition mask or field oxide definition mask with framing field oxide openings for the CMOS transistor structure and also functioning as the collector base surface spacer region definition mask with CBSS definition opening for the bipolar transistor structure.

FIG. 5 is a simplified two dimensional diagrammatic view of the 6.0 mask field oxidation step showing the framing field oxide regions for the CMOS transistor structure and the collector base surface spacer region composed of field oxide for the bipolar transistor structure.

FIG. 6 is a simplified two dimensional diagrammatic view of the 11.0 mask, etch and implant sequence of the new BICMOS fabrication process showing the new emitter and collector sink implant mask with the collector base surface spacer region and nitride layer providing a self-aligned transistor mask.

FIG. 7 is a simplified two dimensional diagrammatic view showing the results of the 14.0 contact definition mask and etch sequence and the 15.0 Metal 1 or M1 mask and deposition step using the LTO as the M1 deposition mask.

FIG. 8 is a graph with a logarithmic vertical scale showing concentrations of respective P and N type dopant atoms along a vertical profile from the surface at the emitter region E down to the buried collector layer BCL for the prior art bipolar transistor structure of FIG. 1.

FIG. 9 is a similar graph showing the improved concentrations of respective P and N type dopant atoms for the bipolar transistor structure of FIG. 2 according to the invention.

Description of Preferred Example Embodiments and Best Mode of the Invention

A new bipolar transistor structure 12 according to the invention is illustrated in FIG. 2. The regions and elements of the bipolar transistor structure 12 of FIG. 2 performing the same or similar function as the regions and elements of the bipolar transistor structure 10 of FIG. 1 are indicated by the same reference designations. The bipolar transistor structure 12 differs by the inclusion of a localized subemitter collector region SEC localized in the base collector layer BCL and implanted with an N+ concentration of relatively fast diffusing phosphorous atoms. During subsequent annealing steps the subemitter collector region SEC therefore forms a retrograde concentration of the N type atoms extending upward from the buried collector layer BCL through the epitaxial layer EPI adjacent to the active base layer ABL as shown by the dashed lines in FIG. 2.

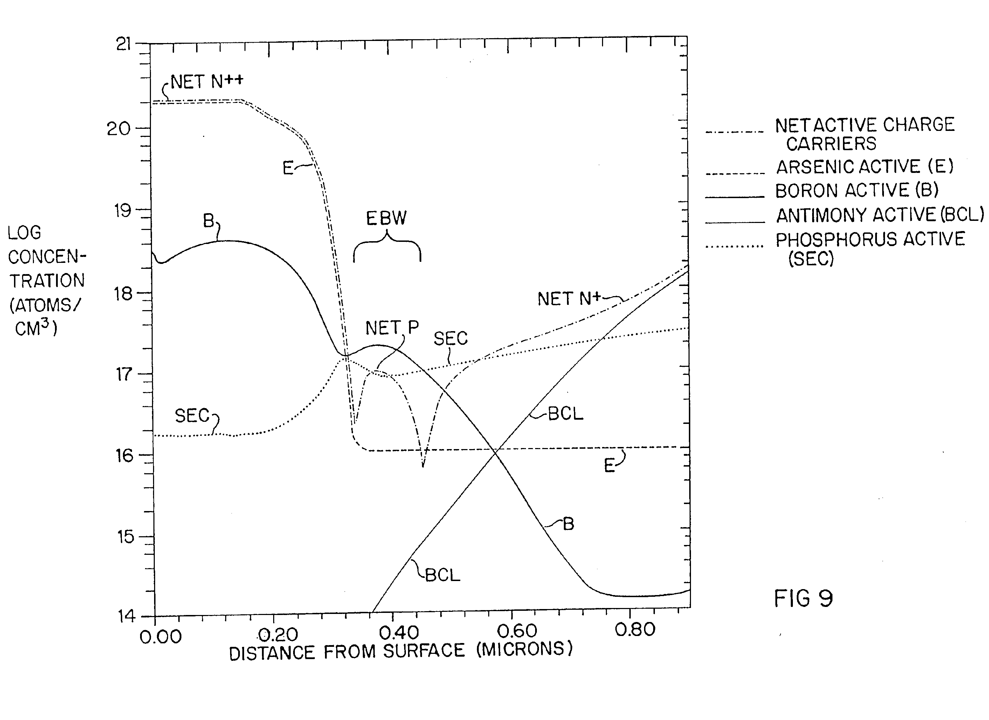

The advantage of the SEC region according to the invention is shown graphically in FIG. 9. The substantial increase in N type carriers in the localized region of the epitaxial layer EPI lying in the transistor electron path reduces the effective base width in comparison with the conventional bipolar transistor element 10 by as much as 30% to 40%. A typical range for the retrograde concentration of N type phosphorous atoms in the bipolar transistor structure 12 is, for example, $6 \times 10^{17}$ atoms/cm$^3$ at the buried collector layer BCL to $6 \times 10^{16}$ atoms/cm$^3$ in the epitaxial layer EPI adjacent to the active base layer ABL. The concentration of N type atoms in the epitaxial layer EPI adjacent to the active base layer ABL for the bipolar transistor structure 12 of FIG. 2 is therefore at least 3 to 4 times greater than the bipolar transistor structure 10 of FIG. 1.

The increase in N type carriers effectively shortens the path of electrons from the base to the collector reducing the effective base width EBW. The bipolar transistor structure 12 therefore increases speed of transistor operation and reduces the parasitic capacitance of the bipolar transistor structure. Furthermore the increased concentration of N type carriers in the epitaxial layer EPI defers onset of the kirk effect.

The bipolar transistor structure 12 of FIG. 2 also differs from the conventional bipolar transistor structure 10 by the inclusion of a collector base surface spacer region CBSS composed of field oxide. The field oxide is also used in framing CMOS transistor structures in a BICMOS integrated circuit as hereafter described. The field oxide FOX provides surface isolation superior to isolation oxide ISOX or epitaxial silicon EPI. The new field oxide CBSS region also provides utility as hereafter described in a self-aligned transistor mask of the BICMOS process.

The BICMOS IC fabrication process for fabricating the bipolar transistor structure 12 according to the invention are illustrated in FIGS. 3-7. The new BICMOS mask structures are also shown in these figures and the overall BICMOS mask sequence is summarized in TABLE I.

TABLE I

BICMOS MASK SEQUENCE

| Mask No. | Mask Function |
|---|---|
| 1.0 | Buried Collector Layer (BCL) Mask |
| 2.0 | Retro NWELL Mask and Retro SEC Mask |
| 3.0 | Retro PWELL/Channel Stop (CHST) Mask |
| 4.0 | Isolation Oxide (ISOX) Mask |
| 5.0 | Sink Implant & ISOX Gettering Mask |
| 6.0 | CMOS Active Area Definition Mask (Field Oxide Mask) & Collector Base Surface Spacer (CBSS) Definition Mask |
| 7.0 | Active Strip Mask |
| 8.0 | Poly Gate Definition Mask |
| 9.0 | Base Definition Mask |
| 10.0 | Nitride Etch Mask or Collector Base & Emitter Contact Definition Mask |
| 11.0 | Emitter & Collector Sink Implant Mask (Self-Aligned Transistor Mask) |
| 12.0 | N+ S/D Source/Drain Mask (NMOS) |
| 13.0 | P+ S/D Source/Drain Mask (PMOS) |
| 14.0 | CMOS Contact Definition Mask |
| 15.0 | METAL 1 (M1) Deposition Mask |
| 16.0 | VIA Mask (Inter Layer Dielectric Mask) |
| 17.0 | METAL 2 (M2) Deposition Mask |
| 18.0 | Passivation Mask |

Referring to FIG. 3, a buried collector layer BCL is first formed in the substrate P SUB using the 1.0 BCL mask etch and implant sequence. Relatively slow diffusing N type antimony atoms are implanted in the P SUB to an N+ concentration through initial oxide layer SIOX. A new photoresist layer is then deposited to form the 2.0 mask. The 2.0 mask is formed to provide not only the retro NWELL definition and implant mask with an NWELL opening for the CMOS transistor structure, but also a subemitter collector region definition and implant mask with an SEC opening for the bipolar transistor structure. By way of example the SEC opening in the 2.0 mask is formed with a horizontal area of approximately 10% and preferably in the range of 10% to 20% of the horizontal cross section area of the BCL. Relatively fast diffusing phosphorous atoms are implanted to an N+ concentration level through the 2.0 mask.

The SEC region is localized within the BCL region to underlay the base and emitter regions of the bipolar transistor structure. In particular the SEC region is arranged to be in vertical alignment with the active base layer ABL as hereafter described. Phosphorous atoms are used for the N+ concentration implant of the SEC and NWELL regions for faster up diffusion during subsequent annealing steps as hereafter described to provide retrograde concentrations extending into the subsequently deposited epitaxial EPI.

The 3.0 mask, etch and implant sequence is used for defining and implanting the retro PWELL region of the CMOS transistor structure and the channel stop regions CHST adjacent to the bipolar transistor structure. Boron atoms are implanted to a P+ concentration level in the PWELL and CHST regions. A single crystal epitaxial layer of N-silicon is then deposited uniformly over the BICMOS IC structure in a blanket epitaxial deposition without a mask.

Isolation oxide regions ISOX are established around the bipolar transistor structures using the 4.0 isolation oxide mask, etch and oxidation sequence. The collector sink region CS is implanted with an N+ concentration of phosphorous atoms using the 5.0 sink mask, etch and implant sequence. The 5.0 mask is also formed for implanting the isolation oxide regions ISOX with the phosphorous atoms as a gettering agent. A uniform nitride layer SIN is deposited in a blanket chemical vapor deposition across the BICMOS structure.

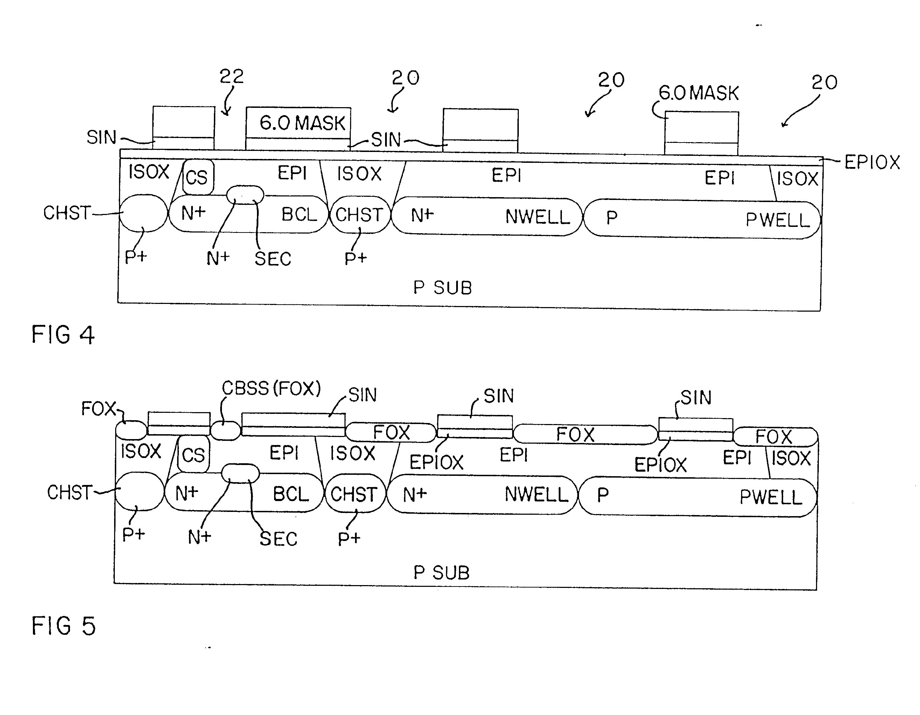

Referring to FIG. 4, the 6.0 active mask is formed for etching the nitride layer SIN and defining the active regions of the CMOS transistor structure. The openings 20 in the 6.0 active mask define the framing field oxide regions FOX for framing the CMOS transistor structure during the subsequent oxidation step illustrated in FIG. 5.

At the same time the 6.0 active mask also functions as the collector base surface spacer region CBSS definition mask for the bipolar transistor structure through opening 22. In the subsequent field oxidation step illustrated in FIG. 5 the collector base surface spacer region CBSS if formed from the field oxide rather than isolation oxide. The CBSS region is oxidized to provide a spacer depth approximately the same as the subsequent base region depth to assure surface isolation and reduce parasitic capacitance.

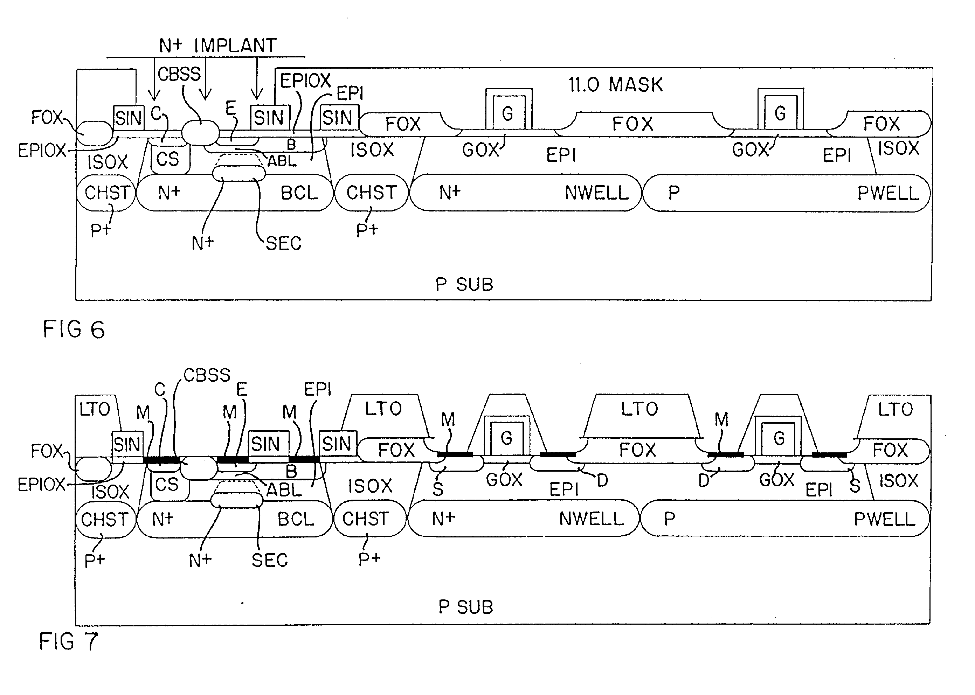

In the 7.0 active strip mask steps the nitride layer SIN is stripped except over the bipolar transistor structure and the active areas of the CMOS transistor structure are opened to expose the epitaxial silicon. The gate oxide layer GOX is grown and polysilicon (POLY) is deposited in one or two layers with doping to adjust the threshold voltage for the CMOS transistor structure. The 8.0 poly gate definition mask steps define the gate using a photoresist layer and photolithographic stepper followed by etching the poly layer and leaving behind the poly gates G over the gate oxide layer GOX as shown in FIG. 6. A thin oxide layer referred to as a sealing oxide or spacer oxide is grown over the poly gates G.

The 9.0 base mask, etch and implant sequence is used for defining and implanting the base of the bipolar transistor structure with P type boron atoms. The 10.0 nitride etch mask provides a collector, base and emitter contact definition mask which is a self-aligned transistor nitride mast over the bipolar transistor structure. The epitaxial oxide layer EPIOX remains over the bipolar transistor structure with the nitride mask defining the collector, base and emitter contacts.

As shown in FIG. 6 the 11.0 emitter and collector sink implant mask is modified to utilize the underlying nitride SAT mask over the bipolar transistor structure. The emitter and collector sink regions are implanted to an N+ concentration level with N type arsenic atoms as further shown in Flr. 6. While previous annealing have begun development of the retrograde concentration upward from the NWELL and the SEC region, the subsequent annealing step following implant of the emitter and collector sink regions fully develops most of the concentration profile of dopant atoms shown in the graph of FIG. 9. The full development of the retrograde submitter collector region SEC with a retrograde concentration extending upward from the base collector layer BCL through the epitaxial layer EPI and adjacent to the active base layer ABL is indicated by the dashed line in FIG. 6.

A blanket N- arsenic implant preceeds the N+ source/drain mask, etch and implant sequence for the NMOS transistor elements. The N+ source/drain implant is a phosphorous implant over the arsenic. The combination of the N- arsenic implant and N+ phosphorous implant develops a profiled lightly doped drain (PLDD) for the NMOS transistor element of the CMOS transistor pair. The characteristic of the PLDD is selected to set the effective channel length of the NMOS transistor structure and the performance of the CMOS transistor pair. The extent of the spacer oxide previously grown over the polygates G may also be used to control the spacing between implants for the source and drain regions, further controlling the channel length. The 13.0 P+ source/drain mask, etch and implant sequence is used for implanting the source and drain regions of the PMOS transistor structure.

Following the source/drain mask, etch and implant sequences for the CMOS and PMOS transistor elements of the CMOS transistor structure, a blanket low temperature oxide layer LTO is deposited over the BICMOS structure. The 14.0 CMOS contact definition mask and etch sequence removes the LTO over the CMOS metal contact areas and over the bipolar transistor structure. The SAT nitride mask remains permanently on the bipolar transistor structure for defining the bipolar transistor metal contact areas. In subsequent mask steps the first metal layer is deposited using the Metal 1 or M1 mask and deposition sequence followed by blanket deposition of an interlayer dielectric (ILD). The ILD is masked and etched using the 16.0 VIA mask followed by deposition of the second metal layer using the 17.0 Metal 2 or M2 mask and deposition sequence. The final 18.0 passivation etch and mask sequence cuts holes in the nitride layer for bond pads.

While the invention has been described with reference to particular example embodiments it is intended to cover all modifications and equivalents within the scope of the following claims.

## Claims

1. An integrated circuit bipolar NPN transistor structure having collector (C), base (B) and emitter (E) regions formed in the surface of an epitaxial layer (EPI) of semiconductor material deposited over a substrate (SUB), said bipolar transistor structure having a buried collector layer (BCL) formed in the substrate underlying the collector (C), base (B) and emitter (E) regions, said buried collector layer (BCL) comprising relatively slow diffusing BCL N type atoms separated from said base and emitter regions by semiconductor material of the epitaxial layer (EPI), and a collector sink region (CS) formed in the epitaxial layer electrically coupling the collector region (C) with the buried collector layer (BCL), said emitter region being formed in the base region with an active base region layer (ABL) below the emitter region, and a surface spacer region (CBSS) separating the collector region (C) and base region (B), the improvement comprising:

a subemitter collector region (SEC) formed in the buried collector layer (BCL) underlying the emitter region (E) and active base region layer (ABL), said subemitter collector region comprising relatively fast diffusing N type atoms distributed in a retrograde concentration upward from the buried collector layer (BCL) into the epitaxial layer (EPI).

2. The bipolar transistor structure of claim 1 wherein the subemitter collector region (SEC) comprises said relatively fast diffusing N type atoms distributed in a retrograde concentration upward from the buried collector layer (BCL) to the active base region layer (ABL) below the emitter region (E).

3. The bipolar transistor structure of claim 1 wherein the subemitter collector region (SEC) comprises semiconductor material with an N+ concentration of phosphorous atoms in the buried collector layer (BCL) and a retrograde concentration of phosphorus atoms distributed upward from the buried collector layer (BCL) into the epitaxial layer (EPI).

4. The bipolar transistor structure of claim 1 wherein the subemitter collector region (SEC) occupies a horizontal cross section area approximately 10% to 20% of the horizontal cross section area of the buried collector layer (BCL).

5. The bipolar transistor structure of claim 1 wherein the surface spacer region (CBSS) between the collector (C) and base (B) regions comprises field oxide.

6. A BICMOS integrated circuit structure comprising at least one bipolar NPN transistor structure having collector (C), base (B) and emitter (E) regions formed in the surface of an epitaxial layer (EPI) of semiconductor material deposited over a substrate (SUB), said bipolar transistor structure having a buried collector layer (BCL) formed in the substrate underlying the collector, base and emitter regions, said buried collector layer comprising relatively slow diffusing BCL N type atoms separated from said base (B) and emitter (E) regions by semiconductor material of the epitaxial layer (EPI), and a collector sink region (CS) formed in the epitaxial layer electrically coupling the collector region (C) with the buried collector layer (BCL) said emitter region being farmed in the base region with an active base region layer (ABL) below the emitter region (E), and a surface spacer region separating the collector region (C) and base region (B), said bipolar transistor structure being isolated in the BICMOS integrated circuit structure by isolation oxide regions (ISOX), and at least one CMOS transistor structure having source (S) and drain (D) regions formed in the epitaxial layer (EPI) separated by a channel region with a gate (G) formed over the channel region separated by a gate oxide layer (GOX), and an N well formed in the substrate underlying the source (S) drain (D) and channel regions, said CMOS transistor structure being framed by field oxide regions (FOX), the improvement comprising:
said bipolar transistor structure having a subemitter collector region (SEC) formed in the buried collector layer (BCL) underlying the emitter region (E) and active base region layer (ABL), said subemitter collector region comprising relatively fast diffusing N type atoms distributed in a retrograde concentration upward from the buried collector layer (BCL) into the epitaxial layer (EPI) to the active base layer region (ABL);
said CMOS transistor structure having a retro N well (NWELL) comprising the relatively fast diffusing N type atoms distributed in a retrograde concentration upward from the substrate (SUB) into the epitaxial layer (EPI) to the source (S), drain (D) and channel regions.

7. The BICMOS IC structure of claim 6 wherein the subemitter collector region (SEC) comprises a localized N+ concentration of phosphorus atoms in the base collector layer (BCL) and a retrograde concentration of phosphorus atoms distributed upward from the buried collector layer (BCL) into the epitaxial layer (EPI) to the active base region layer (BL), and wherein the retro N well (NWELL) comprises an N+ concentration of phosphorus atoms in the substrate and a retrograde concentration of phosphorus atoms distributed upward from the substrate (S) into the epitaxial layer (EPI) to the source (S), drain (D) and channel regions.

8. The BICMOS IC structure of claim 6 wherein the subemitter collector region (SEC) occupies a horizontal cross section area approximately 10% to 20% of the horizontal cross section area of the buried collector layer (BCL).

9. The BICMOS IC structure of claim 6 wherein the surface spacer region (CBSS) separating the collector (C) and base (B) regions comprises field oxide.

10. A BICMOS process for fabrication of at least one bipolar transistor structure and at least one CMOS transistor structure in a BICMOS integrated circuit (IC), said bipolar transistor structure having collector (C), base (B) and emitter (E) regions formed in an epitaxial layer (EPI) of semiconductor material deposited over a substrate (SUB), said bipolar transistor structure having a buried collector layer (BCL) formed in the substrate using a BCL definition mask, etch and implant sequence before deposition of the epitaxial layer, said buried collector layer (BCL) underlying the collector, base and emitter regions and comprising relatively slow diffusing BCL N type atoms separated from the base (B) and emitter (E) regions by semiconductor materials of the epitaxial layer (EPI), said emitter region (E) being formed in the base region (B) with an active base region layer (ABL) below the emitter region, said bipolar transistor structure being isolated by isolation oxide regions (ISOX), said CMOS transistor structure having source (S) and drain (D) regions formed in the epitaxial layer (EPI), said source and drain regions being separated by a channel region with a gate (G) formed over the channel region separated by a gate oxide layer (GOX), and an N well (NWELL) of semiconductor material formed in the substrate underlying the source, drain and channel regions, said CMOS transistor structure being framed by field oxide regions (FOX) formed using a field oxide definition mask, said BICMOS process comprising:

forming the N well (NWELL) of the CMOS transistor structure in the substrate (SUB) using an N well definition mask, etch and implant sequence before deposition of the epitaxial layer, and after forming the buried collector layer (BCL) of the bipolar transistor structure in the substrate, said step of forming the N well comprising implanting relatively fast diffusing N type atoms through an N well defining opening in the N well definition mask and into the substrate;

constructing the N well definition mask also as a subemitter collector (SEC) definition mask with an SEC defining opening over the buried collector layer of the bipolar transistor structure and implanting the relatively fast diffusing N type atoms to form a subemitter collector region (SEC) in the buried collector layer (BCL) of the bipolar transistor structure at the same time as implanting the N well of the CMOS transistor structure.

11. The BICMOS process of claim 10 wherein the relatively fast diffusing N type atoms implanted in the subemitter collector region (SEC) of the bipolar transistor structure and in the N well (NWELL) of the CMOS transistor structure are phosphorus atoms and wherein the step of implanting the phosphorus atoms comprises implanting an N+ concentration of phosphorus atoms in the subemitter collector region and N well.

12. The BICMOS process of claim 10 comprising at least one annealing step after deposition of the epitaxial layer (EPI), formation of the source (S), drain (D) and channel regions of the CMOS transistor structure in the epitaxial layer, and formation of the collector (C), base (B) and emitter (E) regions of the bipolar transistor structure in the epitaxial layer, said annealing step comprising up diffusion of the relatively fast N type atoms from the N well to form a retro N well (NWELL) having a retrograde concentration of said N type atoms distributed from the substrate (SUB) through the epitaxial layer (EPI) to the source (S), drain (D) and channel regions in the CMOS transistor structure, and up diffusion of the relatively fast diffusing N type atoms implanted in the buried collector layer (BCL) forming a subemitter collector region (SEC) comprising a retrograde concentration of said N type atoms distributed from the base collector layer (BCL) through the active epitaxial layer (EPI) to the active base region layer (ABL).

13. The BICMOS process of claim 12 wherein the retrograde concentration of N type atoms in the subemitter collector region ranges from approximately $n \times 10^{17}$ atoms/cm$^3$ at the buried collector layer (BCL) to $n \times 10^{16}$ atoms/cm$^3$ at the base region layer (ABL) where n is approximately equal to 6.

14. The BICMOS process of claim 10 wherein the step of implanting relatively fast diffusing N type atoms to form a subemitter collector region in the buried collector layer comprises implanting and forming the subemitter collector region (SEC) with a horizontal cross section area limited to approximately 10% to 20% of the horizontal cross section area of the buried collector layer (BCL).

15. The BICMOS process of claim 10 further comprising the step of constructing the field oxide definition mask also as a collector base surface spacer region definition mask with a CBSS defining opening over the bipolar transistor structure, and defining and growing a field oxide surface spacer region (CBSS) separating the collector region (C) from the base region (B) of the bipolar transistor element.

16. The BICMOS process of claim 15 comprising the further step of using the field oxide collector base surface spacer region (CBSS) as part of a self-aligned transistor mask comprising the collector, emitter and base contact definition mask.

17. The BICMOS process of claim 12 wherein the retrograde concentration of N type atoms of the subemitter collector region (SEC) provides a net concentration of N type carriers at the junction of the active base region layer (BL) and the subemitter collector region (SEC) of approximately $6 \times 10^{16}$ atoms/$CM^3$.

18. BICMOS integrated circuit (IC) photodefinition mask means for fabrication of bipolar transistor structures and CMOS transistor structures in IC bipolar transistor active areas and CMOS transistor active areas, said bipolar transistor structures having collector (C), base (B) and emitter (E) regions formed in an epitaxial layer (EPI) and a buried collector layer (BCL) underlying the collector, base and emitter regions, said CMOS transistor structures having source (S) and drain (D) regions separated by a channel region formed in the epitaxial layer (EPI) and an underlying N well, comprising:

a retro N well photodefinition mask comprising a first mask layer formed with N well definition openings for implanting a retro N well in CMOS transistor active areas, said retro N well definition mask also comprising a subemitter collector definition mask being formed with subemitter collector definition openings through said first mask layer for implanting a subemitter collector region (SEC) in the buried collector layer (BCL) of bipolar transistor active areas at a location positioned to be below the emitter region (E) of bipolar transistor structures to be fabricated, said N well definition and subemitter collector definition mask being constructed for implanting the retro N well in CMOS transistor active areas and the subemitter collector in bipolar transistor active areas at the same time.

19. The BICMOS IC photodefinition mask means of claim 18 wherein the subemitter collector definition openings in the retro N well photodefinition mask have an area approximately 10% to 20% of the horizontal cross section area of the buried collector layer (BCL).

20. The BICMOS IC photodefinition mask means of claim 19 further comprising:

a field oxide definition mask comprising a second mask layer formed with openings defining framing field oxide regions for framing the CMOS transistor active areas, said field oxide definition mask also comprising a surface spacer region definition mask formed with openings defining collector base surface spacer regions (CBSS) for separating collector regions and base regions in bipolar transistor structures of the bipolar transistor active areas.

10

C E EPIOX

| SIN | | SIN | | SIN | | SIN |

CBS B
ISOX CS ABL N- EPI ISOX

CHST
P+ N+ BCL CHST
P+

P SUB

FIG 1 (PRIOR ART)

12 E EPIOX

C

| SIN | | SIN | | SIN | | SIN |

CBSS B
ISOX CS ABL EPI ISOX

N+
SEC

CHST
P+ N+ BCL CHST
P+

P SUB

FIG 2

N+ IMPLANT

2.0 MASK

SIOX

N+ SEC BCL N+ NWELL

P SUB

FIG 3

FIG 4

FIG 5

FIG 6

FIG 7

FIG 8
(PRIOR ART)

FIG 9